# EUROPÄISCHE PATENTSCHRIFT

(11) **EP 2 459 992 B1**
(45) Veröffentlichungstag und Bekanntmachung des Hinweises auf die Patenterteilung: **17.09.2014**
(21) Anmeldenummer: 10737270.8
(22) Anmeldetag: 14.07.2010
(51) Int. Cl.: G01N 23/20, H01J 49/02

(54) **GEHÄUSE MIT SEPARATEM GETTERRAUM FÜR UNTER VAKUUM ARBEITENDES GERÄT**
HOUSING HAVING SEPARATE GETTER CHAMBER FOR DEVICE OPERATING UNDER VACUUM
BOÎTIER POURVU D'UN COMPARTIMENT À GETTER SÉPARÉ POUR UN APPAREIL FONCTIONNANT SOUS VIDE

(30) Priorität: 27.07.2009 DE 102009034837
(43) Veröffentlichungstag der Anmeldung: 06.06.2012
(73) Patentinhaber: GSI Helmholtzzentrum für Schwerionenforschung GmbH, 64291 Darmstadt (DE)
(72) Erfinder: ENGERT, Tobias, 69518 Abtsteinach (DE); KOJOUHAROV, Ivan, 55270 Zornheim (DE); GERL, Jürgen, 63128 Dietzenbach (DE)
(86) Internationale Anmeldenummer: PCT/EP2010/004266
(87) Internationale Veröffentlichungsnummer: WO 2011/012224

(56) Entgegenhaltungen:
- DE-A1- 4 324 709
- US-A- 5 317 157
- US-B1- 6 908 595

## Beschreibung

Die Erfindung betrifft ein Gehäuse, insbesondere ein Gehäuse für unter Vakuum und/oder Schutzgas betriebene Geräte, das zumindest einen Gehäuseinnenraum sowie zumindest einen Aufnahmebereich zur Aufnahme eines Gettermaterials aufweist. Weiterhin betrifft die Erfindung ein Gerät, insbesondere ein unter Vakuum und/oder Schutzgas betriebenes Gerät.

Für viele Messaufgaben im Forschungsumfeld ist es erforderlich, Messelemente zu verwenden, welche von äußeren Einflüssen geschützt werden müssen. Bei derartigen äußeren Einflüssen kann es sich beispielsweise um Temperatureinflüsse (bzw. auch ganz allgemein um zu hohe oder zu niedrige Temperaturen), Materialeinflüsse, Vibrationseinflüsse und dergleichen handeln. Ein derartiger Schutz ist in der Regel erforderlich, um die oftmals empfindlichen Messeinrichtungen vor Beschädigung oder Zerstörung zu schützen. Alternativ oder zusätzlich können die äußeren Einflüsse auch zu einer Verfälschung der Messergebnisse bzw. einer Verschlechterung der Messgenauigkeit führen. Beide Effekte sind aus nachvollziehbaren Gründen unerwünscht.

Ein Beispiel unter vielen sind beispielsweise Gamma-Spektrometer, welche zur Spektroskopie von Gamma-Strahlung verwendet werden. Derartige Gamma-Spektrometer werden in vielen Bereichen der Forschung und der industriellen Anwendung eingesetzt. Bewährt haben sich dabei Detektoren aus hochreinem Germanium, die eine sehr gute Energieauflösung und eine hohe Nachweiswahrscheinlichkeit aufweisen. Derartige Gamma-Detektoren weisen sehr empfindliche Oberflächen auf. Daher müssen die Gamma-Detektoren unter Vakuum (vorzugsweise Hochvakuum oder Ultrahochvakuum) betrieben werden, damit die empfindlichen Oberflächen des eigentlichen Germanium-Detektors vor einer Beschädigung durch Umgebungsluft geschützt werden. Die Germanium-Detektoren reagieren jedoch nicht nur empfindlich, wenn diese einer gasförmigen Belastung ausgesetzt werden, sondern insbesondere auch dann, wenn die Oberfläche durch Feststoffe verschmutzt wird. Beide Anforderungen können in erster Nährung durch eine Kapselung des Germanium-Detektors in einem geschlossenen Gehäuse erreicht werden.

Ein zusätzliches Problem ergibt sich jedoch dann, wenn das (Ultra-) Hochvakuum im geschlossenen Gehäuse über längere Zeiträume aufrecht erhalten werden muss. Bei derartig hohen Vakua ist nämlich auch bei Wänden aus Metall (wie beispielsweise Edelstahl) über Zeiträume von mehreren Wochen oder Monaten hinweg ein Ausgasen des Materials in merklichem Umfang möglich, wenn keine Gegenmaßnahmen getroffen wurden, wie insbesondere ein Vorbehandeln der Oberfläche im Vorfeld. Dies macht es erforderlich, dass das Innere des Gehäuses, in dem der Detektor untergebracht ist, stetig nachgepumpt werden muss, um das (Ultra-) Hochvakuum aufrecht zu erhalten. Werden für diesen Zweck "klassische" Pumpen verwendet (was durchaus möglich ist), so hat dies zur Folge, dass die vollständige Detektoreinheit kaum beweglich ist und darüber hinaus in aller Regel äußerst empfindlich auf Erschütterungen reagiert. Darüber hinaus wird die Detektoreinheit auch deutlich größer und unverhältnismäßig teurer. Zum dauerhaften Pumpen von derartigen Detektoreinheiten werden daher üblicherweise sogenannte Getterelemente verwendet. Diese können durch chemische und/oder physikalische Sorption gasförmige Substanzen dauerhaft binden. Auf diese Weise können derartige Getterelemente vorteilhaft über lange Zeiträume hinweg als Pumpe für geschlossene Kapseln eingesetzt werden.

Damit sich das Gettermaterial nicht durch die Sorption von Gasen vor dem Evakuieren und vakuumdichten Verschluss des Gehäuses vorzeitig erschöpft, werden zwischenzeitlich üblicherweise thermisch aktivierbare Getterelemente verwendet. Diese Elemente beginnen ihre Sorptionstätigkeit im Wesentlichen erst dann, wenn diese durch Erhitzen auf Temperaturen von typischerweise über 450° C bis hin zu 900° C aktiviert worden sind. In der Praxis werden derartig aktivierbare Getterelemente in dem Gehäuse mit eingeschlossen und anschließend durch Anlegen eines elektrischen Heizstroms (entsprechende Stromleitungen für das Getterelement müssen vorgesehen werden) auf die Aktivierungstemperatur gebracht. Ein typisches Beispiel für ein derartiges thermisch aktivierbares Getterelement ist ein handelsüblicher St 172 SAES-Getter mit der Handelsbezeichnung HIS/7-6. Gegebenenfalls sind zur optimalen Aktivierung des Getterelements auch komplexere Aktivierungszyklen (wie beispielsweise mehrmaliges Aufheizen und abkühlen lassen erforderlich).

Eine derartige Kapsel für einen im Ultrahochvakuum arbeitenden Detektor ist beispielsweise in WO 95/03555 A1 beschrieben. Der im Ultrahochvakuum arbeitende Detektor zur Gamma-Spektroskopie ist in einer Kapsel eingesetzt, die zur Aufrechterhaltung des Ultrahochvakuums ein ausheizbares Getterelement aufweist. Das Getterelement ist innerhalb der Kapsel in einer vom Detektor durch einen thermischen Schutz getrennten Getterbüchse angeordnet, um beim Ausheizen des Getters den Detektor, bei dem es sich insbesondere einen Germanium-Detektor handeln kann, nicht durch Überhitzung zu schädigen. Die thermische Isolierung von Detektor und Getterelement wird durch eine mäanderartige Kanalführung eines zwischen dem Detektor und dem Getterelement angeordneten Kanals realisiert. Es hat sich jedoch gezeigt, dass insbesondere im Hochvakuum bei einer mäanderartigen Kanalführung keine ausreichende Pumpleistung durch das Getterelement erzielt werden kann. Darüber hinaus ist nach wie vor eine Verschmutzung und Beschädigung des Detektors durch sich vom Getterelement lösende Partikel möglich.

Ein weiteres Gehäuse mit separatem Getterraum ist aus US 5317157 bekannt, wobei eine Passage Gas durchlässt, Partikel aber nicht.

Die Aufgabe der Erfindung besteht somit darin, ein gegenüber dem Stand der Technik verbessertes Gehäuse vorzuschlagen, welches insbesondere für unter Vakuum und/oder Schutzgas betriebene Geräte geeignet ist. Darüber hinaus besteht die Aufgabe der Erfindung darin ein gegenüber dem Stand der Technik verbessertes Gerät, insbesondere ein unter Vakuum und/oder Schutzgas betriebenes Gerät vorzuschlagen.

Dazu wird ein Gehäuse vorgeschlagen, welches zumindest einen Gehäuseinnenraum sowie zumindest einen Aufnahmebereich zur Aufnahme eines Gettermaterials aufweist, und das derart ausgebildet ist, dass die Verbindung zwischen dem zumindest einen Gehäuseinnenraum und dem zumindest einen Aufnahmebereich zur Aufnahme eines Gettermaterials als partikelundurchlässige Verbindung ausgeführt ist. Insbesondere kann es sich bei dem Gehäuse um ein Gehäuse für unter Vakuum und/oder Schutzgas zu betreibende oder betriebene Geräte handeln. Unter einem Gettermaterial ist insbesondere - wie allgemein üblich - ein Material zu verstehen, welches Substanzen (insbesondere gasförmige Substanzen) durch chemische und/oder physikalische Sorption binden kann und auf diese Weise aus der Umgebung "entfernen" kann. Mit einem derartigen Gettermaterial ist es insbesondere möglich, einen Unterdruck bzw. ein Vakuum (speziell Hochvakuum und/oder Ultrahochvakuum) zu erzeugen bzw. auf längere Zeit hinweg aufrecht zu erhalten. Beim Gehäuse ist ein (in der Regel großvolumig ausgelegter) Gehäuseinnenraum vorgesehen, welcher beispielsweise der Aufnahme eines Detektors, einer sonstigen Messeinrichtung und/oder einer sonstigen technischen Vorrichtung dient. Zusätzlich ist in dem Gehäuse ein Aufnahmebereich vorgesehen, welcher insbesondere der Aufnahme eines Gettermaterials (wie vorab beschrieben), und gegebenenfalls auch sonstiger Einrichtungen dienen kann, bei denen es bevorzugt ist, dass diese in einem gewissen Ausmaß getrennt vom Gehäuseinnenraum und/oder von den darin aufgenommenen technischen Vorrichtungen angeordnet werden sollen. Um eine besonders hohe Funktionalität, beispielsweise eines in einem Hochvakuum zu betreibenden Detektors, welcher in dem Gehäuseinnenraum aufgenommen ist, zu gewährleisten, ist es wünschenswert, dass eine möglichst direkte und unmittelbare fluidische Verbindung (insbesondere hinsichtlich Gasen) zwischen dem Aufnahmebereich und dem Gehäuseinnenraum des Gehäuses gewährleistet ist. Andererseits ist es in der Regel sehr schädlich, wenn Partikel - beispielsweise Partikel die in dem Gettermaterial, welches im Aufnahmebereich des Gehäuses angeordnet ist, aufgrund der Sorption von Gasen entstehen, und anschließend vom Gettermaterial-"Block" abfallen können - in Kontakt mit der im Gehäuseinnenraum angeordneten Vorrichtung (wie beispielsweise einem Detektor) in Kontakt treten. Um eine derartige Beeinträchtigung bzw. Beschädigung der im Gehäuseinnenraum angeordneten Vorrichtung zumindest weitestgehend zu vermeiden wird daher vorgeschlagen, die Verbindung zwischen dem zumindest einen Gehäuseinnenraum und dem zumindest einen Aufnahmebereich als partikelundurchlässige Verbindung auszuführen. Ein wesentlicher (oftmals auch der wesentliche) Aspekt der partikelundurchlässigen Verbindung ist dabei die Undurchlässigkeit in Bezug auf Partikel, insbesondere in Bezug auf Partikel in fester Form. Weitere Aspekte der vorgeschlagenen partikelundurchlässigen Verbindung können - je nach Anforderung - jedoch auch eine besonders geringe Länge des Verbindungskanals und/oder ein besonders großer Querschnitt des Verbindungskanals sein. Mit einer derartigen Bauausführung ist es beispielsweise möglich, eine vergleichsweise hohe Pumprate mit Hilfe des Gettermaterials zu erzielen. Je nach Erfordernis kann es sich auch als sinnvoll erweisen, die Verbindung zwischen dem Gehäuseinnenraum sowie dem Aufnahmebereich zusätzlich thermisch isolierend auszugestalten (um so gegebenenfalls die im Gehäuseinnenraum angeordnete Vorrichtung auch in thermischer Hinsicht zu schützen). Umgekehrt kann sich eine derartige, thermisch isolierende Ausbildung der Verbindung zwischen Gehäuseinnenraum und Aufnahmebereich aber auch als nachteilig erweisen, da eine derartige thermisch isolierende Ausbildung in aller Regel mit einem erhöhten Widerstand in Bezug auf den Durchgang von Fluiden (insbesondere von Gasen) einhergeht, insbesondere wenn es sich um Fluidbewegungen im Vakuum (speziell Hochvakuum und/oder Ultrahochvakuum) handelt. In diesem Fall kann der thermische Schutz - sofern notwendig - auch durch andere technische Maßnahmen realisiert werden.

Insbesondere wird vorgeschlagen, das Gehäuse derart auszubilden, dass die partikelundurchlässige Verbindung zumindest eine Filtereinrichtung aufweist. Die Filtereinrichtung ist dabei bevorzugt so ausgestaltet, dass sie Gase, gegebenenfalls auch Flüssigkeiten und/oder überkritische Fluide mit einem vorzugsweise nur geringen Fluidwiderstand hindurch lassen kann, Partikel in Feststoffform (gegebenenfalls auch Partikel in flüssiger Form) dagegen zu einem möglichst großen Anteil zurückhält. Die Filtereinrichtung kann dabei beispielsweise einlagig oder mehrlagig aufgebaut sein. Selbstverständlich ist es auch möglich, dass die Filtereinrichtung ein oder mehrere Prinzipien zur Filterung der entsprechenden, zurückzuhaltenden Partikeln nutzt. Vorzugsweise weist zumindest eine Filtereinrichtung zumindest ein Maschengewebe, vorzugsweise eine Mehrzahl von Maschengeweben auf. Derartige Maschengewebe können - je nach Ausführung - Partikel weitestgehend zurück halten, gasförmige Stoffe (gegebenenfalls auch sonstige Fluide) dagegen mit einer nur relativ geringen Behinderung derselben durchlassen. Je nach Dichte des Maschengewebes (bzw. der Maschengewebe) können beispielsweise Partikel, die eine gewisse Größe überschreiten, zurück gehalten werden. Vorteilhaft bei den Maschengeweben ist auch, dass diese beispielsweise aus Stahl oder einem sonstigen Material gefertigt werden können, welches einerseits eine hohe Festigkeit aufweist, andererseits auch auf einfache Weise der Art behandelt werden kann, dass dieses speziell beim Vakuumeinsatz keine virtuellen Lecks erzeugt (gegebenenfalls nach entsprechender Behandlung, wie beispielsweise einem vorherigen Reinigen oder einem Ausheizen der Anlage). Darüber hinaus sind Filter aus einem Maschengewebe (oder mehreren Maschengeweben) beispielsweise auf dem Gebiet der Lebensmitteltechnik kommerziell erhältlich, so dass eine kostengünstige Umsetzung der vorgeschlagenen Lösung möglich ist. Für den Fall, dass mehrere Maschengewebe vorgesehen sind, können diese in beliebiger Weise (zum Teil) mit einer gleichartigen Maschenweite und/oder mit verschiedenen Maschenweiten ausgebildet werden.

Bevorzugt ist das Gehäuse derart ausgebildet, dass zumindest ein Aufnahmebereich zur Aufnahme eines Gettermaterials zumindest bereichsweise in einem massiv ausgeführten Gehäusebereich ausgebildet ist. Insbesondere kann es sich dabei um einen Deckel (insbesondere Deckendeckel und/oder Bodendeckel) des Gehäuses handeln, welcher in der Regel ohnehin eine relativ große Dicke aufweist. Eine derartige größere Dicke ist beispielsweise erforderlich, um Durchführungseinrichtungen, wie Hochspannungsdurchführungen, Gasdurchführungsleitungen, Messzuleitungen und dergleichen aufnehmen zu können, wobei darauf hinzuweisen ist, dass die Durchführungseinrichtungen vakuumdicht ausgeführt sein sollten. Da bei der vorgeschlagenen Bauausführung in aller Regel bislang ungenutzter Bauraum verwendet werden kann, ist es möglich einen "Verlust" an Hohlraum, der der Aufnahme von technischen Vorrichtungen im Gehäuseinnenraum dient, zu vermeiden. Auch ist es möglich, die partikelundurchlässige Verbindung in der Regel technisch besonders einfach durchzuführen.

Weiterhin wird vorgeschlagen, zumindest ein Gettermaterial vorzusehen, welches bevorzugt in zumindest einem der Aufnahmebereiche zur Aufnahme eines Gettermaterials angeordnet ist. Besonders bevorzugt kann dabei zumindest ein Gettermaterial als thermisch aktivierbares Gettermaterial ausgebildet sein. Besonders bevorzugt ist, wenn das Gettermaterial bei niedrigen Temperaturen aktivierbar ist. Beispielsweise kann es sich hierbei um Gettermaterial handeln, das bei einer Temperatur bis zu 300 °C, 400 °C, 450 °C, 600 °C, 700 °C aktivierbar ist. Wird - wie vorgeschlagen - Gettermaterial in einem Aufnahmebereich angeordnet, welcher partikelundurchlässig mit dem Gehäuseinnenraum verbunden ist, so kann ein besonders hoher Schutz vor Beschädigung oder Zerstörung der im Gehäuseinnenraum aufgenommenen technischen Vorrichtung (wie beispielsweise einem Detektor, insbesondere einem Halbleiter-Detektor) bei gleichzeitig nach wie vor guter Pumpleistung durch das Gettermaterial hindurch realisiert werden. Wenn es sich bei dem Gettermaterial um ein thermisch aktivierbares Gettermaterial handelt, so kann ein "Verbrauch" des Gettermaterials durch Sorption vor dem vakuumdichten Verschluss des Gehäuses weitgehend vermieden werden. Insbesondere ist es auch möglich, das Vakuum (insbesondere ein Ultrahochvakuum) im Gehäuse über eine besonders lange Zeitdauer hinweg aufrecht zu erhalten, insbesondere wenn das Gettermaterial in bestimmten Zeiträumen durch thermische Aktivierung "reaktiviert" wird. Dank der vorgeschlagenen, partikelundurchlässigen Verbindung zwischen Gehäuseinnenraum und Aufnahmebereich ist es dabei auch in aller Regel unschädlich, falls sich im Rahmen der Sorption von Gasen und/oder während der Aufheizung des Gettermaterials Partikel vom Gettermaterial lösen sollten.

Vorteilhaft kann es sein, wenn zumindest eine, die Gehäusewand durchdringende Durchführungseinrichtung vorgesehen ist, die bevorzugt fluiddicht verschlossen werden kann. Der Begriff des fluiddichten Verschließens kann sich dabei sowohl auf die Durchführungseinrichtung selbst (beispielsweise wenn diese röhrenartig ausgebildet ist) und/oder auf deren Einpassung in die Gehäusewand (insbesondere einen Deckel) beziehen. Bei der Durchführungseinrichtung kann es sich beispielsweise um eine Hochspannungsdurchführung, eine Stromdurchführung, Messzuleitungen, Gasdurchführungsleitungen, Leitungen, die der Evakuierung des Gehäuseinnenraums dienen, usw. handeln. Insbesondere in dem Fall, dass eine Fluiddurchführungseinrichtung (wie beispielsweise ein Rohr, welches zur Ausbildung eines Vakuums dient), verwendet wird, ist es auf besonders einfache Weise möglich, auch nach der Fertigstellung des Gehäuses und dem Verschluss desselben, dieses zu evakuieren und/oder mit einer bestimmten Gasfüllung (wie beispielsweise einem Schutzgas) zu befüllen. Nach der Befüllung bzw. Evakuierung kann die Fluiddurchführungseinrichtung verschlossen werden. Um den Verschluss der Fluiddurchführungseinrichtung zu bewirken, kann ein mechanisches Verformen (beispielsweise durch ein Zusammenquetschen) und/oder ein stoffschlüssiger Verschluss (z. B. durch Einbringen einer Art von Pfropfen) bewirkt werden. Danach ist es insbesondere möglich, das Gehäuse (samt dem darin angeordneten Detektor) problemlos als selbstständige Einheit zu handhaben. Insbesondere dann, wenn ein stoffschlüssiger Verschluss der Fluiddurchführungseinrichtung verwendet wird, kann die Gefahr einer späteren Leckage in aller Regel wirkungsvoll verringert werden.

Vorteilhaft ist es weiterhin, wenn bei dem Gehäuse wenigstens eine thermische Isolationseinrichtung vorgesehen ist, welche in zumindest einem Verbindungsbereich in der Nähe wenigstens einer stoffschlüssigen Verbindungsnaht vorgesehen ist. Um ein Gehäuse auszubilden, ist es in aller Regel erforderlich eine oder mehrere Verbindungsnähte vorzusehen, entlang derer die Einzelteile des Gehäuses miteinander verbunden werden. Insbesondere zur Ausbildung von vakuumdichten Verbindungen, haben sich stoffschlüssige Verbindungsnähte (beispielsweise Lötnähte, Schweißnähte, Klebenähte und dergleichen) bewährt. Stoffschlüssige Verbindungsnähte erfordern zu ihrer Ausbildung jedoch in aller Regel eine Beaufschlagung mit thermischer Energie. Diese Energie kann beispielsweise mit einem Laser (z. B. Excimerlaser, Halbleiterlaser, CO₂-Laser, Farbstofflaser, Festkörperlaser, Gaslaser), einer Schallquelle (z. B. Ultraschallquelle), einer Elektronenstrahlquelle, einer elektrischen Widerstandsvorrichtung, einer elektrischen Hochspannungsquelle, einer Reibungsenergieeintragsvorrichtung oder einer sonstigen Energieeintragsvorrichtung in den Bereich der Verbindungsnaht eingebracht werden. Wird nun, wie vorgeschlagen, in der Nähe wenigstens einer stoffschlüssigen Verbindungsnaht eine thermische Isolationseinrichtung vorgesehen, ist es auf besonders einfache Weise möglich, die gegebenenfalls in den Bereich der Verbindungsnaht eingebrachte thermische Energie im Verbindungsbereich zu belassen. Mit anderen Worten, es wird gegebenenfalls weniger Wärmeenergie aus dem Verbindungsbereich abtransportiert. Dadurch kann es ermöglicht werden, den gegebenenfalls erforderlichen Wärmeeintrag zu verringern. Somit können benachbarte Bereiche des Gehäuses vor unnötiger thermischer Belastung geschützt werden. Dies gilt natürlich auch für Teile, Vorrichtungen und weitere Baugruppen (wie z.B. Messelemente, Sensoren, Kabel, Detektoren usw.), die in einem bestimmten Bereich mit dem Gehäuse verbunden sind. Durch die in aller Regel niedrigere thermische Belastung des Werkstoffs kommt es üblicherweise auch zu einer geringeren Freisetzung von Gasen beziehungsweise sonstigen Materialfreisetzungen im Verlauf der Ausbildung der stoffschlüssigen Verbindungsnaht. Unter einer stoffschlüssigen Verbindungsnaht kann im vorliegenden Zusammenhang im Übrigen auch eine Anordnung (z. B. eine linienförmige Anordnung) von Verbindungspunkten verstanden werden. Die thermische Isolationseinrichtung verbleibt in aller Regel dauerhaft im Gehäuse (wie beispielsweise in einer Gehäusewand). Dies schließt es natürlich nicht aus, dass beispielsweise eine thermische Isolationseinrichtung nach Ausbildung der stoffschlüssigen Verbindungsnaht beispielsweise ausgehärtet oder verfüllt werden kann. Durch das Vorsehen einer thermischen Isolationseinrichtung kann es zwar zu einer Schwächung des betreffenden Gehäusebereichs kommen, da die thermische Isolationseinrichtung in aller Regel eine niedrigere strukturelle Festigkeit aufweist, als dies beim übrigen Material der Gehäusewandung der Fall ist. Wie die Erfinder jedoch überraschenderweise herausgefunden haben, werden die nachteiligen Effekte dieser Ausbildungsweise in der Regel durch deren Vorteile deutlich überkompensiert. Dies gilt insbesondere, wenn die thermische Isolationseinrichtung - wie oben erwähnt - nach Ausbildung der stoffschlüssigen Verbindungsnaht ausgehärtet und/oder verfüllt wird, und dadurch die gegebenenfalls vorhandene strukturelle Schwächung in aller Regel zumindest gemindert werden kann. Vorteilhaft kann es auch sein, wenn wenigstens eine stoffschlüssige Verbindungsnaht als thermische Verbindungsnaht, insbesondere als Lötnaht und/oder als Schweißnaht ausgebildet ist. Derartige thermische Verbindungsnähte, bei denen die stoffschlüssige Verbindung in der Regel dadurch erfolgt, dass es zu einem zumindest bereichsweisen Aufschmelzen bzw. zu einer zumindest bereichsweisen Erweichung eines der beteiligten Materialien kommt, führen oftmals zu besonders festen und dauerhaften Verbindungen. Auch lassen sich derartige thermische Verbindungsnähte oftmals besonders schnell ausbilden. Wird die Zufuhr an thermischer Energie beendet, so kühlt der Verbindungsbereich in aller Regel sehr rasch ab, so dass nach kurzer Zeit eine belastbare Verbindung vorlegt. Insbesondere können Aushärtezeiten, wie sie bei der Verwendung von Kleber in aller Regel vorkommen, verkürzt werden.

Es kann sich als sinnvoll erweisen, wenn wenigstens eine thermische Isolationseinrichtung als Materialverdünnung, insbesondere als Ausnehmung, bevorzugt als nutartige Ausnehmung und/oder stegartiger Vorsprung ausgebildet ist. Eine derartige thermische Isolationseinrichtung lässt sich in besonders einfacher Weise durch mechanische Bearbeitungsmaßnahmen, wie beispielsweise materialabtragende Bearbeitungsverfahren und/oder materialumformende Bearbeitungsverfahren realisieren. Insbesondere ist es in aller Regel nicht erforderlich, Maßnahmen zur Befestigung der thermischen Isolationseinrichtung am bzw. im betreffenden Gehäusebereich vorzusehen. Die thermische Isolationseinrichtung kann auch bereits bei der Herstellung des betreffenden Gehäuses (beziehungsweise der Gehäusebaugruppen) berücksichtigt werden, beispielsweise wenn zumindest Teile des Gehäuses durch ein Strangpressverfahren hergestellt werden.

Als besonders sinnvoll kann es sich bei dem vorgeschlagenen Gehäuse erweisen, wenn zumindest zwei der miteinander verbundenen Verbindungsbereiche, insbesondere zwei miteinander verbundene Gehäuseteile, zumindest bereichsweise eine unterschiedliche Dicke aufweisen. Bei bisherigen stoffschlüssigen Verbindungsverfahren führte die Wärmeabfuhr durch den dickeren Verbindungsbereich oftmals dazu, dass ein sehr hoher thermischer Energieeintrag erfolgen musste. Dieser thermische Energieeintrag musste oftmals so hoch gewählt werden, dass der dünnere Verbindungsbereich dadurch beschädigt werden konnte. Dementsprechend waren derartige Verbindungen oftmals nicht ausreichend stabil bzw. nicht ausreichend dauerhaft. Zum Teil waren derartige Gehäuseanordnungen auch nicht darstellbar, sodass auf andere Verbindungsverfahren ausgewichen werden musste.

Es ist möglich, das Gehäuse so auszubilden, dass zumindest zwei Verbindungsbereiche des Gehäuses zumindest bereichsweise mit einer Übergangspassung und/oder mit einer Presspassung versehen sind, insbesondere mit einer H7-Passung. Dadurch ist es während der Herstellung des Gehäuses auf einfache Weise möglich, eine definierte Lagevorfixierung der betreffenden Gehäuseteile zueinander zu realisieren. Auch kann durch eine solche Passung die Tiefe einer Schweißnaht bzw. einer Lötnaht geeignet begrenzt werden. Ein weiterer Vorteil kann sich dadurch ergeben, dass eine derartige Passung einen gewissen Widerstand für gegebenenfalls während der Ausbildung der stoffschlüssigen Verbindungsnaht freiwerdende Stoffe aufweisen kann. Dadurch kann eine Kontamination des Gehäuseinneren auf sehr einfache Weise wirksam verringert und ggf. sogar im Wesentlichen vollständig unterbunden werden. Die Verwendung einer H7-Passung hat sich dabei als einfach und kostengünstig herstellbar, gleichzeitig jedoch als besonders effektiv erwiesen.

Als besonders vorteilhaft kann es sich erweisen, wenn bei dem Gehäuse zwischen einem Gehäusemantel und einem Gehäusedeckel und/oder einem Gehäuseboden zumindest eine Verbindungsnaht vorgesehen ist. Da üblicherweise Gehäusedeckel und/oder Gehäuseböden mit zumindest einer Durchführungsvorrichtung versehen werden müssen, müssen diese üblicherweise mit einer relativ großen Dicke ausgebildet werden. Demgegenüber kann der Gehäusemantel oftmals relativ dünnwandig ausgeführt werden. Für einen Großteil von Detektoranwendungen ist es im Übrigen erforderlich, dass die Gehäusung zumindest bereichsweise relativ dünnwandig ausgeführt ist, damit beispielsweise zu detektierende Gammastrahlung in das behälterinnere eindringen kann, um auf das eigentliche Detektormaterial einwirken zu können. Von daher ist es zur Ausbildung des Gehäuses in aller Regel erforderlich derartige, mit stark unterschiedlichen Dicken versehene Bauteile miteinander zu verbinden. Zur Ausbildung derartiger Verbindungen hat sich insbesondere eine Verbindungsnaht vom vorab beschriebenen Typ bewährt.

Weiterhin kann es sich als vorteilhaft erweisen, wenn zumindest ein Gehäuseteil, insbesondere zumindest ein Verbindungsbereich, zumindest ein Material aufweist, welches der Gruppe entnommen ist, die Metall, Metalllegierungen, Aluminium, Aluminiumlegierungen, AlMg₃, AlMg₄,₅Mn, Stahl, Stahliegierungen, Edelstahl, Kupfer, Kupferlegierungen, Nickel, Nickellegierungen, abdampfarme Materialien und/oder abdampffreie Materialien umfasst. Mit derartigen Materialien können besonders haltbare und besonders feste Verbindungen besonders gut ausgebildet werden. Insbesondere bei abdampfarmen bzw. abdampffreien Materialien kann auch das bereits erwähnte, unerwünschte Abdampfen von Zuschlagsstoffen verringert, minimiert oder sogar beseitigt werden.

Besonders vorteilhaft kann es sein, wenn wenigstens eine Verbindungsnaht, insbesondere eine stoffschlüssige Verbindungsnaht trennbar ausgeführt ist, und insbesondere geöffnet werden kann, bevorzugt geöffnet und erneut geschlossen werden kann. Dies ist beispielsweise dann möglich, wenn zur Ausbildung der stoffschlüssigen Verbindungsnaht ein zusätzliches Material eingesetzt wird, welches beispielsweise einen besonders niedrigen Schmelzpunkt bzw. Materialzerstörungspunkt aufweist. Wird der entsprechende Verbindungsbereich auf bzw. über die entsprechende Temperatur erhitzt (was insbesondere auf Grund der thermischen Isolationseinrichtung besonders einfach möglich sein kann), so kann die Verbindung auf diese Weise gelöst, gegebenenfalls auch erneut verschlossen werden. Möglich ist es selbstverständlich auch, den Bereich mit der Verbindungsnaht abzutrennen. Dies kann beispielsweise auf mechanischem Wege erfolgen, wie beispielsweise unter Verwendung von Verfahren, die gemäß der Einteilung der Fertigungsverfahren nach DIN 8580 unter dem Oberbegriff "Trennen" zusammengefasst sind. Insbesondere kann das Abtrennen durch Sägen, Drehen, Fräsen oder Feilen erfolgen. Das Abtrennen kann jedoch auch auf anderem Wege erfolgen, wie beispielsweise unter Verwendung eines Lasers. Das Abtrennen ist durch das Vorsehen einer thermischen Isolationseinrichtung besonders einfach möglich, insbesondere dann, wenn die thermische Isolationseinrichtung als Ausnehmung ausgebildet wird. Unter einer trennbaren Ausführung sind selbstverständlich nicht nur solche Ausbildungen zu verstehen, die sehr häufig bzw. im Wesentlichen beliebig häufig getrennt und wiederverbunden werden können, sondern auch solche Ausbildungen, bei denen nur eine gewisse Anzahl an Trennvorgängen (beispielsweise zwei, drei, vier, fünf, sechs, sieben, acht, neun oder zehn) möglich ist.

Weiterhin wird ein Gerät vorgeschlagen, insbesondere ein unter Vakuum und/oder Schutzgas betriebenes Gerät, welches wenigstens ein Gehäuse mit dem oben beschriebenen Aufbau aufweist. Ein derartiges Gerät weist die bereits im Zusammenhang mit dem vorgeschlagenen Gehäuse beschriebenen Eigenschaften und Vorteile in analoger Weise auf. Dabei kann das Gerät bevorzugt als Detektor insbesondere als Halbleiterdetektor ausgebildet sein. Derartige Detektoren bzw. Halbleiterdetektoren, die in einem Gehäuse angeordnet sind, werden beispielsweise zur Detektion radioaktiver Strahlung bzw. zur Detektion von Teilchenstrahlung (Alphastrahlung, Betastrahlung, Protonen, Neutronen, Elektronen, Atomkerne usw.) verwendet. Damit diese möglichst gute Messeigenschaften aufweisen (insbesondere ein gutes Detektionsvermögen und ein geringes Rauschen) müssen diese in der Regel im Vakuum und/oder gekühlt betrieben werden. Das vorgeschlagene Gerät weist damit eine deutliche Verbesserung gegenüber bekannten Geräten auf.

Im Folgenden wird die Erfindung anhand von Ausführungsbeispielen und unter Bezugnahme auf die Figuren detailliert beschrieben. Einander entsprechende Bauteile sind in den Figuren mit gleichen Bezugszeichen versehen. Es zeigen:
- Fig. 1:: Ein erstes Ausführungsbeispiel für einen in einer Vakuumkapsel gekapselten Halbleiterdetektor in schematischem Querschnitt;
- Fig. 2:: ein erstes Ausführungsbeispiel für eine Schweißnaht zur Verbindung von zwei Baugruppen im schematischen Querschnitt;
- Fig. 3:: ein zweites Ausführungsbeispiel für eine Schweißnaht zur Verbindung von zwei Baugruppen im schematischen Querschnitt;
- Fig. 4:: ein drittes Ausführungsbeispiel für eine Schweißnaht zur Verbindung von zwei Baugruppen im schematischen Querschnitt;
- Fig. 5a-d:: ein Ausführungsbeispiel für die Ausbildung eines vakuumdichten Verschlusses des Evakuierungsrohrs und dessen anschließende Ablängung.

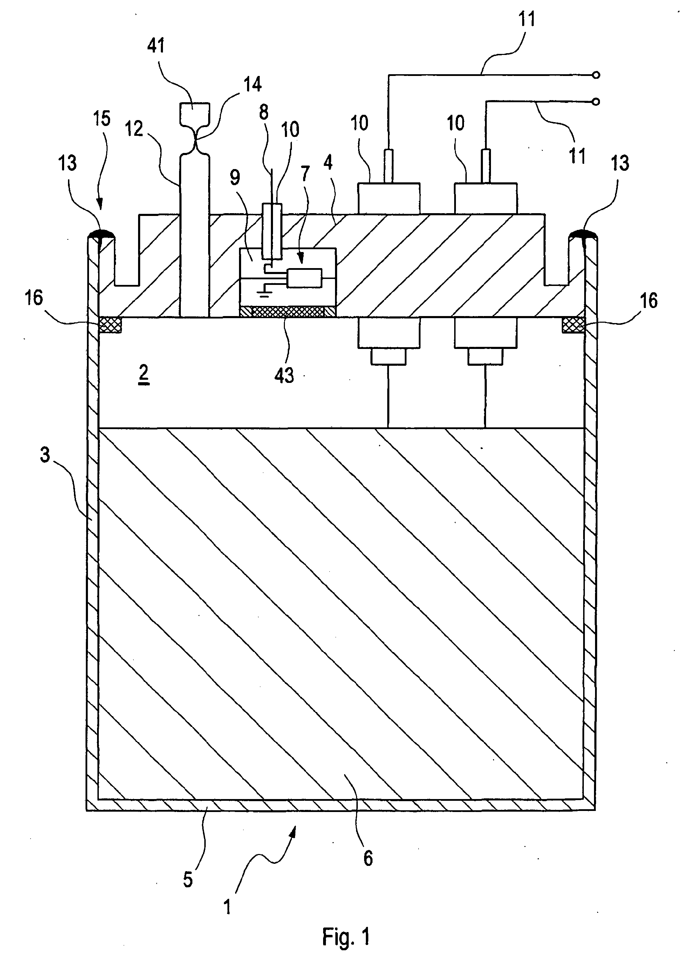

Fig. 1 zeigt in einer schematischen Querschnittsansicht ein erstes Ausführungsbeispiel für eine Detektorkapsel 1. Die Detektorkapsel 1 weist einen Hohlraum 2 auf, der von der Kapseldose 3 sowie von einem Deckel 4 gebildet wird. Die Kapseldose 3 ist relativ dünnwandig ausgebildet. Im vorliegend dargestellten Ausführungsbeispiel ist die Kapseldose 3 aus einem Aluminiumblech mit einer Wandstärke von 1 mm gebildet. Der Boden 5 der Detektorkapsel 1 ist dabei als integraler Teil der Kapseldose 3 ausgebildet. Die Kapseldose 3 kann beispielsweise durch ein Tiefziehverfahren hergestellt werden. Demgegenüber ist der Deckel 4 der Detektorkapsel 1 deutlich dickwandiger ausgeführt. Im vorliegend dargestellten Ausführungsbeispiel beträgt die Dicke des Deckels 15 mm.

Im Hohlraum 2 der Detektorkapsel 1 ist ein Halbleiterdetektormaterial 6 (beispielsweise hochreines Germanium) angeordnet. Das Halbleiterdetektormaterial 6 kann beispielsweise zur Spektroskopie von Gammastrahlung verwendet werden. Um das Halbleiterdetektormaterial 6 und insbesondere dessen Oberflächen zu schützen, wird der Hohlraum 2 der Detektorkapsel 1 evakuiert, steht also unter einem Vakuum.

Um im Hohlraum 2 der Detektorkapsel 1 dauerhaft ein Vakuum aufrecht erhalten zu können, und somit eine möglichst lange Standzeit der verschlossenen Detektorkapsel 1 realisieren zu können, wird im vorliegenden Beispiel das in der Detektorkapsel 1 befindliche Hochvakuum stetig nachgepumpt. Dazu wird im vorliegend dargestellten Ausführungsbeispiel ein thermisch aktivierbarer Ionengetter 7 verwendet. Unterhalb des Ionengetters 7 ist ein Filterelement 43 angeordnet, das den Hohlraum 9, der im Deckel 4 ausgebildet ist, und den Hohlraum 2, der in der Kapseldose 3 ausgebildet ist, "partiketmäßig" trennt. Somit können keine Partikel aus dem Hohlraum 9, der in dem Deckel 4 ausgebildet ist, in den Hohlraum 2, der in der Kapseldose 3 ausgebildet ist, gelangen. Der thermisch aktivierbare Ionengetter 7 kann über eine elektrische Anschlussleitung 8, die vakuumdicht durch den Deckel 4 der Detektorkapsel 1 hindurch geführt wird, mit einem elektrischen Strom beaufschlagt, und somit beheizt werden (der Massenschluss erfolgt über den Deckel 4 und/oder die Kapseldose 3 der Detektorkapsel 1). Der thermisch aktivierbare Ionengetter 7 ist vorliegend in einem gesonderten Hohlraum 9 angeordnet, der in dem massiv ausgebildeten Deckel 4 (vorliegend mit einer Dicke von 15 mm) der Detektorkapsel 1 ausgebildet wurde. Dadurch kann der im Inneren der Kapseldose 3 vorhandene Hohlraum 2 bestmöglich zur Aufnahme von Halbleiterdetektormaterial 6 genutzt werden, und es muss im Hohlraum 2 kein Volumen zur Aufnahme des thermisch aktivierbaren Ionengetters 7 zur Verfügung gestellt werden.

Weiterhin sind im Deckel 4 der Detektorkapsel 1 Spannungsdurchführungen 10 zu erkennen. Über diese Spannungsdurchführungen 10 kann das Halbleiterdetektormaterial 6 über elektrische Leitungen 11 mit elektrischem Strom versorgt werden, bzw. können vom Halbleiterdetektormaterial 6 elektrische Signale (insbesondere Messsignale) abgeführt werden. Sämtliche Spannungsdurchführungen (also die Spannungsdurchführungen 10 der elektrischen Leitungen 11 sowie die Spannungsdurchführung der elektrischen Anschlussleitung 8) sind vakuumdicht ausgeführt.

Weiterhin ist in Deckel 4 eine weitere Bohrung vorgesehen, in der ein Evakuierungsrohr 12 - ebenfalls vakuumdicht - eingepasst ist. Über das Evakuierungsrohr 12 kann der Hohlraum 2 der Detektorkapsel 1 evakuiert werden. Das Evakuierungsrohr 12 kann durch übliche Befestigungsverfahren im Deckel 4 befestigt werden. Beispielsweise bieten sich Klebeverfahren, Lötverfahren oder Schweißverfahren an. Da die Verbindung von Evakuierungsrohr 12 und Deckel 4 zeitlich und räumlich vor der Montage des Deckels 4 in der Kapseldose 3 erfolgen kann, können hierfür Verbindungsverfahren verwendet werden, die für das Halbleiterdetektormaterial eigentlich problematisch sind. Insbesondere können Schweißverfahren und/oder Lötverfahren verwendet werden, bei denen es zu einer Freisetzung von gasförmigen Substanzen kommt (z. B. Verdampfung von Anteilen eines Flussmittels). Entsprechendes gilt selbstverständlich auch für die Montage der Spannungsdurchführungen 10.

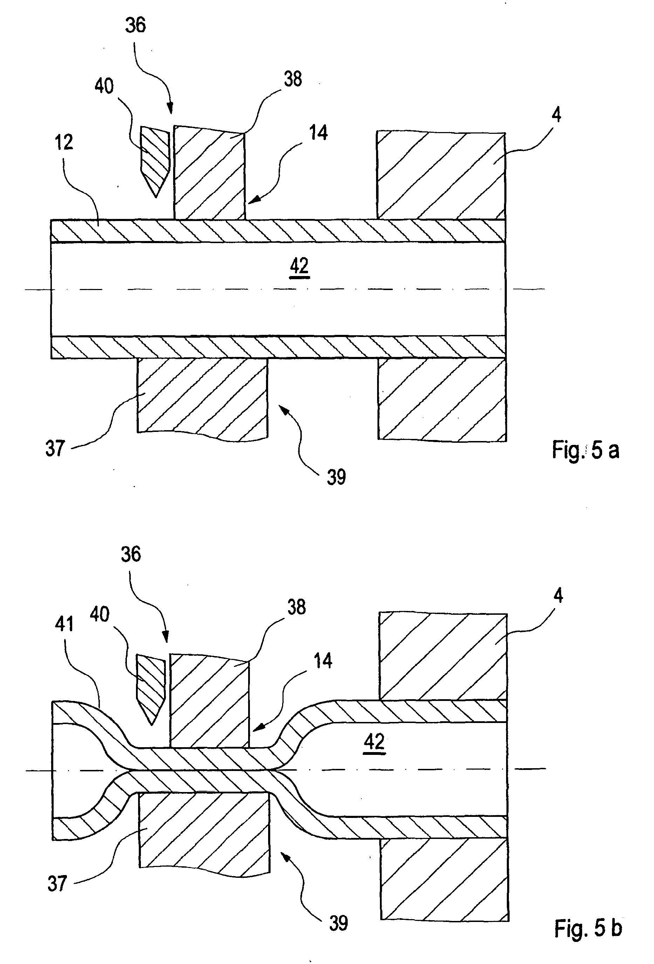

Nachdem die einzelnen Teile der Detektorkapsel 1 zusammengesetzt wurden (also insbesondere Halbleiterdetektormaterial 6, Kapseldose 3 und Deckel 4) und die erforderlichen elektrischen Verbindungen ausgebildet wurden (insbesondere zwischen den Spannungsdurchführungen 10 im Deckel 4 und dem Halbleiterdetektormaterial 6) werden die Schweißnähte 13 ausgebildet, mit denen die Detektorkapsel 2 vakuumdicht verschlossen wird. Dabei ist das Evakuierungsrohr 12 zunächst noch unverschlossen. Nun wird über das Evakuierungsrohr 12 der Hohlraum 2 der Detektorkapsel 1 evakuiert. Sobald im Hohlraum 2 ein Vakuum vorhanden ist, wird auch das Evakuierungsrohr 12 in einem Verschlussbereich 14 vakuumdicht verschlossen. Dies kann beispielsweise unter Verwendung des in den Fig. 5a - 5d skizzierten Verschlussverfahrens erfolgen.

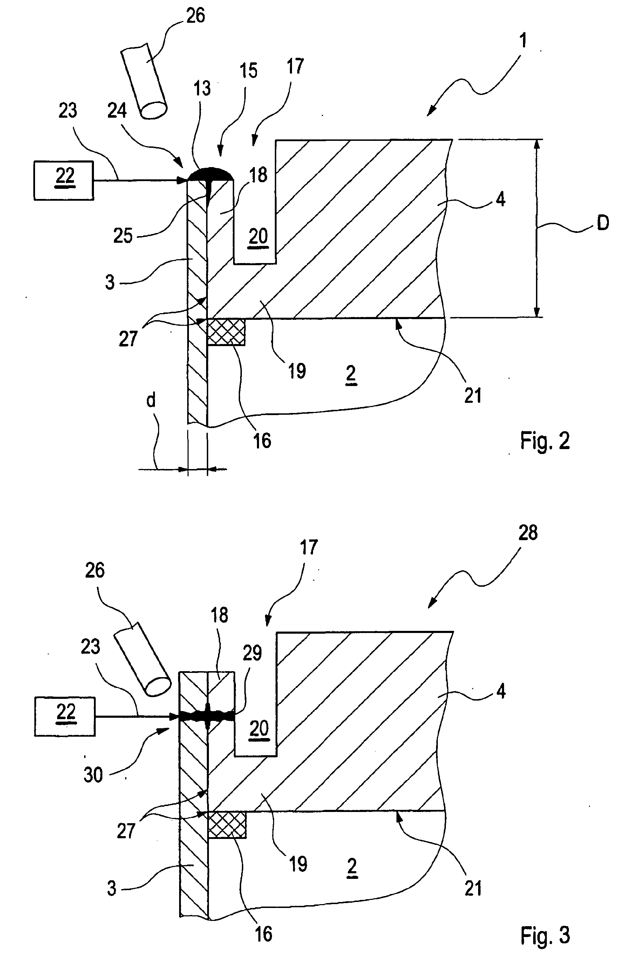

Die Ausbildung der Schweißnähte 13 bei dem in Fig. 1 dargestellten Ausführungsbeispiel der Detektorkapsel 1 wird im Folgenden unter Bezugnahme auf Fig. 2 näher erläutert. Fig. 2 zeigt einen vergrößerten Ausschnitt des Verbindungsbereichs 15 der Detektorkapsel 1.

Wie bereits erwähnt, weist die Kapseldose 3 eine Wandstärke von 1 mm auf. Es handelt sich damit gemäß DIN 1623 um ein Feinblech (nach DIN 1623 wird unter einem Feinblech ein Blech mit einer Dicke d von d ≤ 3 mm verstanden). Der Deckel 4 weist dagegen eine deutlich größere Dicke von vorliegend D = 15 mm auf. Er unterfällt der Definition für ein Grobblech nach DIN EN 1002,9 (hiernach sind Grobbleche durch eine Dicke D von D ≥ 3 mm definiert). Selbstverständlich können für die Dicke d der Kapseldose 3, und/oder für die Dicke D des Deckels 4 auch andere Werte verwendet werden. In vorliegend dargestelltem Ausführungsbeispiel bestehen sowohl der Deckel 4, als auch die Kapseldose 3 aus einer Aluminiumlegierung. Die Aluminiumlegierungen von Kapselhülle 3 und Deckel 4 sind vorliegend im Wesentlichen übereinstimmend gewählt.

Deckel 4 (welcher beispielsweise als kreisrunde Scheibe ausgebildet ist) und Kapseldose 3 (welche beispielsweise die Form eines kreisrunden, zylindrischen Bechers einnimmt) sind so dimensioniert, dass sie im Wesentlichen passgenau ineinander gesteckt werden können. Dabei verbleibt im Verbindungsbereich 15 von Kapseldose 3 und Deckel 4 naturgemäß ein gewisses Spiel (auch Toleranz genannt). Im vorliegend dargestellten Ausführungsbeispiel wurde eine H7-Passung nach EN 20286 realisiert. Aufgrund der engen Passung wird eine mechanische Vorfixierung von Kapseldose 3 und Deckel 4 vor der Ausbildung der Schweißnaht 13 erreicht. Dazu wird beispielsweise der Außendurchmesser des Deckels 4 mit 79,60 mm gewählt, während der Innendurchmesser der Kapseldose 3 81,40 mm beträgt. Eine weitere mechanische Vorfixierung von Deckel 4 und Kapseldose 3 ergibt sich durch einen Stützsteg 16, der auf der Innenseite der Kapseldose 3 vorgesehen ist.

Wie in Fig. 2 gut zu erkennen ist, weist der Deckel 4 in seinem, den Kontaktbereich zugewandten Randbereich 17 einen hinterschnittenen Kontaktsteg 18 auf, der die Kapseldose 3 flächig berührt und dadurch einen Kontaktbereich 27 ausbildet. Der Kontaktsteg 18 ist über einen Brückensteg 19 mit dem eigentlichen Deckel 4 verbunden. Die Hinterschneidung des Kontaktstegs 18 ergibt sich durch eine Nut 20, welche sich zwischen dem Kontaktsteg 18 und dem Hauptkörper 21 des Deckel 4 befindet.

Wie man ebenfalls Fig. 1 gut entnehmen kann, weist der Kontaktsteg 18 eine Länge auf, die geringer ist als es der Dicke D des Hauptkörpers 21 des Deckels 4 entspricht. Dadurch ist der Verbindungsbereich 15 und die Schweißnaht 13 in einem gewissen Ausmaß gegenüber mechanischen Einwirkungen von außen geschützt. In vorliegend dargestellten Ausführungsbeispiel weist die Länge des Kontaktstegs (18) 12 mm auf, die Dicke des Kontaktstegs 18 beträgt 0,9 mm und die Dicke des Brückenstegs 19 beträgt 2 mm. Selbstverständlich sind auch andere Dimensionen wählbar, wie beispielsweise eine Länge des Kontaktstegs 18 von 2,5 mm und eine Dicke des Brückenstegs 19 von 9,5 mm.

Um den Deckel 4 mit der Kapseldose 3 zu verbinden wird von einem CO₂-Laser 22 ein Laserstrahl 23 erzeugt, der im vorliegend dargestellten Ausführungsbeispiel in einem Stirnbereich 24 von Kapseldose 3 und Deckel 4 auf den Verbindungsbereich 15 auftrifft. Die Laserleistung kann beispielsweise 2 kW oder 2,5 kW betragen. Vorliegend wird der Laserstrahl 23 im Wesentlichen normal zur Fläche der Kapseldose 3 dem Verbindungsbereich 15 zugeführt. Selbstverständlich ist es auch möglich, den Laserstrahl 23 unter anderen Winkeln dem Verbindungsbereich 15 zuzuführen. Hier bieten sich beispielsweise Winkel von 0° (parallel zur Oberfläche der Kapseldose 3 im Verbindungsbereich 15), von 30°, von 45° und/oder von 60° an. Der auftreffende Laserstrahl 23 verursacht im Stirnbereich 24 des Verbindungsbereichs 15 eine lokale Erhitzung. Die Parameter des Laserstrahls 23 sind so eingestellt, dass sich die Aluminiumlegierung der Kapseldose 3 und des Deckels 4 in teigiger bzw. flüssiger Form verbindet und gleichzeitig ein Teil der flüssigen Masse in die vorgegebene Toleranz des Kontaktbereichs 27 zwischen Kapseldose 3 und Deckel 4 eintritt. Auf diese Weise wird eine Schweißnaht 13 ausgebildet. Das in den Kontaktbereich 27 eingetretene flüssige Material bildet die in Fig. 1 erkennbare Schweißnahtwurzel 25 aus. Durch die vorliegend gewählte H7-Passung weist die Schweißnahtwurzel 25 nach Fertigstellung der Schweißnaht 13 eine nur geringfügige Dicke auf, und tritt insbesondere nicht in das Kapselinnere (Hohlraum 2) aus.

Gleichzeitig mit dem Laserstrahl 23 wird über eine Schutzgasdüse 26 ein Schutzgas in den Bereich der Schweißnaht 13 geführt. Dadurch wird eine Oxidation des Materials im Bereich der Schweißnaht 4 durch Luftsauerstoff vermieden. Als Schutzgas wird vorliegend Neon verwendet. Das über die Schutzgasdüse 26 zugeführte Schutzgas dient gleichzeitig als so genannter "Cross Jet". Das heißt, dass Verbrennungsrückstände, die gegebenenfalls vom geschmolzenen Material (Schmelzbad) freigesetzt werden, vom Gasstrahl aus dem Schmelzbad in die Nut 20 ausgeblasen werden. Auch dadurch wird ein Eintrag von Verunreinigungen in den Hohlraum 2 der Detektorkapsel 1 - und damit eine Verunreinigung der Oberfläche des Halbleiterdetektormaterials 6 vermieden.

Durch die Hinterschneidung des Kontaktstegs 18 mit Hilfe der Nut 20 steht nur eine geringe Wärmeleitfläche zur Verfügung, durch die Wärme von der Schweißnahtstelle (Verbindungsbereich 15) abgeführt werden kann. Die Nut 20 wirkt somit als thermische Isolationseinrichtung zur Ausbildung der Schweißnaht 13. Natürlich führt das Vorsehen der Nut 20 auch zu einer Schwächung der mechanischen Festigkeit des Deckels 4 in seinem Randbereich 17. Da, wie aus den Fig. 1 und 2 leicht ersichtlich ist, jedoch die Kapseldose 3 den mechanisch kritischsten Teil der Detektorkapsel 1 in diesem Bereich darstellt, ist die Schwächung der Stabilität des Deckels 4 im Wesentlichen ohne Bedeutung.

Im in Fig. 2 dargestellten Ausführungsbeispiel ist es möglich, dass die Kapseldüse 3 und der Deckel 4 ohne Zusatzwerkstoffe und/oder ohne Schweißzusätze miteinander verschweißt werden können. Da auf derartige Materialien verzichtet werden kann, kommt es während des Schweißvorgangs im Bereich der Schweißnaht 13 lediglich - falls überhaupt - zu einer minimalen Freisetzung von Dämpfen. Dies ist sehr vorteilhaft, da das Halbleiterdetektormaterial 6, welches sich im Hohlraum der Kapseldose 3 befindet, in aller Regel sehr empfindlich auf derartige Gasfreisetzungen reagiert. Darüber hinaus ist darauf hinzuweisen, dass eventuell freiwerdende Dämpfe bevorzugt nach oben hin (und damit nicht in den Hohlraum 2 der Detektorkapsel 1 hinein) austreten, da der Laserstrahl 23 im Stirnbereich 24 von Kapseldose 3 und Kontaktsteg 18 des Deckels 4 auftritt. Weiterhin verhindert der relativ lange Kontaktbereich 27 (mit einer H7-Passung) zwischen Kapseldose 3 und Kontaktsteg 18 des Deckels 4 sehr wirkungsvoll einen Durchgang von gasförmigen Materialien in den Hohlraum 2 der Detektorkapsel 1 hinein. Darüber hinaus kann auch der Stützsteg 16 einen zusätzlichen Schutz des Hohlraums 2 der Detektorkapsel 1 vor gegebenenfalls freiwerdenden Dämpfen bewirken. Alle diese Eigenschaften und insbesondere deren Kombination schützen das im Hohlraum 2 der Detektorkapsel 1 befindliche Halbleiterdetektormaterial 6 überaus effektiv.

Ein weiterer Vorteil von einer Verschweißung von Kapseldose 3 und Deckel 4 im Stirnbereich 24 ist darin zu sehen, dass ein Öffnen (und gegebenenfalls ein anschließendes Wiederverschließen) der derart verschlossenen Detektorkapsel 1 besonders leicht möglich ist. Ein Öffnen der Detektorkapsel 1 ist beispielsweise durch eine entsprechende Temperaturbeaufschlagung des Schweißnahtbereichs 13 (einschließlich Schweißnahtwurzel 25) möglich. Möglich ist jedoch auch ein mechanischer Abtrag des Stirnbereichs 24. Insbesondere bei einem mechanischen Abtrag ist die Anzahl der möglichen Öffnungsvorgänge aus geometrischen Gründen naturgemäß beschränkt.

Natürlich dient der Stützsteg 16 gleichzeitig als Auflagefläche, und damit als eine Art "Anschlag", der den Abstand zwischen dem Halbleiterdetektormaterial 6 und dem Deckel 4 der Detektorkapsel 1 definiert. Dadurch ist es insbesondere auch möglich, dass der Abstand zwischen dem Halbleiterdetektormaterial 6 und dem Deckel 4 auch nach einem gegebenenfalls mehrmaligen Öffnen und Wiederverschließen der Detektorkapsel 1 konstant gehalten werden kann.

In Fig. 3 ist ein weiteres mögliches Ausführungsbeispiel für einen Kapsel-Deckel-Verschluss 28 dargestellt. Analog zu Fig. 2 ist lediglich ein vergrößerter Ausschnitt in einem Kontaktbereich 27 aus Deckel 4 und Kapseldose 3 dargestellt. Ansonsten entspricht der in Fig. 3 dargestellte Kapsel-Deckel-Verschluss 28 in weiten Teilen dem in Fig. 2 dargestellten Verbindungsbereich 15 der Detektorkapsel 1. Dementsprechend sind einander entsprechende Bauteile mit gleichen Bezugszeichen versehen.

Im Unterschied zu Fig. 2 ist bei dem vorliegend dargestellten Kapsel-Deckel-Verschluss 28 die Schweißnaht 29 jedoch in einem mittleren Bereich 30 des Kontaktbereichs 27 zwischen Kapseldose 3 und Kontaktsteg 18 des Deckels 4 vorgesehen. Durch die mittlere Anordnung 30 der Schweißnaht 29 weist die Verbindung eine besonders hohe Festigkeit auf. Denkbar ist es natürlich auch, eine mittlere Schweißnaht 30 (Fig. 3) mit einer randseitigen Schweißnacht 13 (Fig. 2) zu kombinieren, um auf diese Weise eine nochmals verstärkte Verbindung zu erzielen.

Trotz der Lage der Schweißnaht 29 in einem mittleren Bereich 30 des Kontaktbereichs 27 treten praktisch keine gegebenenfalls freiwerdenden Gase in den Hohlraum 2 der Detektorkapsel 1 ein. Denn vorliegend kann die Vorderseite der Schweißnaht 29 (dem Laser 22 zugewandt), insbesondere jedoch auch die Rückseite der Schweißnaht 29 (der Nut 20 zugewandt) ein Ausströmen eventuell freiwerdender Gase ermöglichen. Die gegebenenfalls freiwerdenden Gase entweichen somit über die Nut 20 zur Außenseite der Detektorkapsel 1 hin. Der analog zur Fig. 2 vorgesehene Stützsteg 16 bewirkt auch hier eine zusätzliche Barriere für im Bereich der Schweißnaht 29 gegebenenfalls freiwerdende Gase.

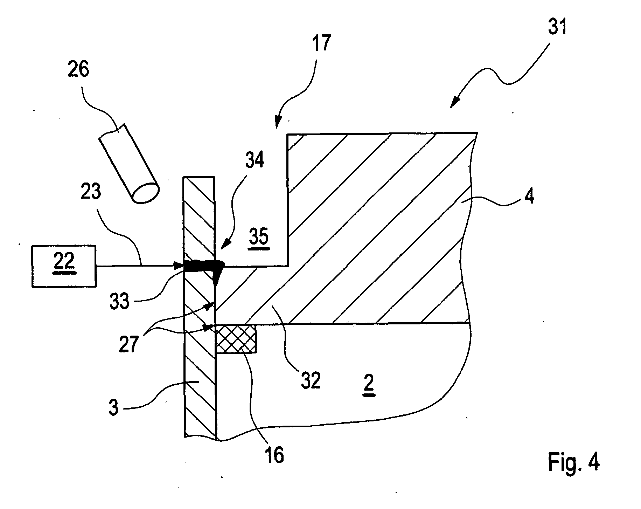

In Fig. 4 ist ein weiterer Kapsel-Deckel-Verschluss 31 für eine Detektorkapsel 1 dargestellt. Im vorliegend dargestellten Ausführungsbeispiel ist im Randbereich 17 des Deckels 4 lediglich ein dünner, stegartiger Vorsprung 32 vorgesehen. Es fehlt somit ein Kontaktsteg 18, wie er in Fig. 1, 2 und 3 vorgesehen ist. Ein Vorteil einer derartigen Anordnung ist, dass der Deckel 4 einfacher zu fertigen ist. Die Schweißnaht 33 wird im in Fig. 4 dargestellten Ausführungsbeispiel an der der Außenseite der Detektorkapsel 1 zugewandten Randseite 34 des stegartigen Vorsprungs 32 ausgebildet. Der Laserstrahl 23 wird dabei von der Außenseite der Kapseldose 3 durch die Kapseldose 3 hindurch dem Kontaktbereich 27 zwischen Kapseldose 3 und stegartigem Vorsprung 32 des Deckels 4 zugeführt. Zur mechanischen Vorfixierung kann erneut ein Stützsteg 16 vorgesehen werden.

Die thermische Isolation der in Fig. 3 dargestellten Schweißnaht 33 liegt in Form des dünnen, stegartigen Vorsprungs 32 vor. Mit anderen Worten wird durch den relativ kleinen Materialquerschnitt des stegartigen Vorsprungs 32 eine nur relativ geringe thermische Energie von der Schweißnaht 33 abgeführt. Dadurch ist es ebenfalls möglich, eine sehr dünne Kapseldose 3 mit einem dicken Deckel 4 zu verschweißen. Eventuell im Bereich der Schweißnaht 33 während des Schweißvorgangs freiwerdende Verbrennungsdämpfe können über die Vorderseite der Schweißnaht 33 (Außenseite der Kapseldose 3) insbesondere aber auch über den Hohlraum 35 (gebildet von Kapseldose 3, stegartigem Vorsprung 32 und Deckel 4; entspricht von der Funktion her der Nut 20) nach außen entweichen. Erneut kommt es auch hier zu keiner relevanten Kontamination des Hohlraums 2 der Detektorkapsel 1, wobei auch hier der Stützsteg 16 eine zusätzliche Gasbarriere bildet.

In den Fig. 5a - 5d wird der vakuumdichte Verschluss des Evakuierungsrohrs 12 des Deckels 4 der Detektorkapsel 1 nach der Evakuierung der Detektorkapsel 1 näher erläutert.

Zunächst wird im Verschlussbereich 14 ein Kombinationswerkzeug 36 an das Evakuierungsrohr 12 angesetzt. Das Kombinationswerkzeug 36 weist eine Ambosssonotrode 37 und eine dazu korrespondierende Schweißsonotrode 38 auf, die zusammen ein Ultraschallschweißwerkzeug 39 ausbilden. Benachbart zur Schweißsonotrode 38 des Ultraschallschweißwerkzeugs 39 ist zusätzlich noch ein Schneidwerkzeug 40 angeordnet. Ambosssonotrode 37, Schweißsonotrode 38 sowie Schneidwerkzeug 40 sind beweglich angeordnet (beispielsweise an Roboterarmen) und können entsprechend bewegt werden. Gegebenenfalls ist es auch möglich, dass mehrere Bauteile des Kombinationswerkzeugs 39 an einer gemeinsamen Halterung befestigt sind und über geeignete Aktuatoren angesteuert werden können.

Die Ambosssonotrode 37 sowie die Schweißsonotrode 38 des Ultraschallschweißwerkzeugs 39 sind verhältnismäßig stabil ausgeführt. Dies macht es möglich, dass der Innenquerschnitt 42 des Evakuierungsrohrs 12 mit Hilfe des Kombinationswerkzeugs 39 (insbesondere mittels der Ambosssonotrode 37 und der Schweißsonotrode 38) zusammengequetscht werden kann, derart, dass sich die Innenwände des Evakuierungsrohrs 12 gegenseitig berühren. Die resultierende Quetschstellung ist in Fig. 5b dargestellt.

Nachdem die in Fig. 5b dargestellte Quetschstellung des Evakuierungsrohrs 12 erreicht ist, werden Ambosssontrode 37 und/oder Schweißsonotrode 38 des Ultraschallschweißwerkzeugs 39 mit Ultraschall beaufschlagt. Dadurch kommt es zu einer Ultraschallverschweißung der Innenwände des Evakuierungsrohrs 12 im Verschlussbereich 14 des Evakuierungsrohrs 12.

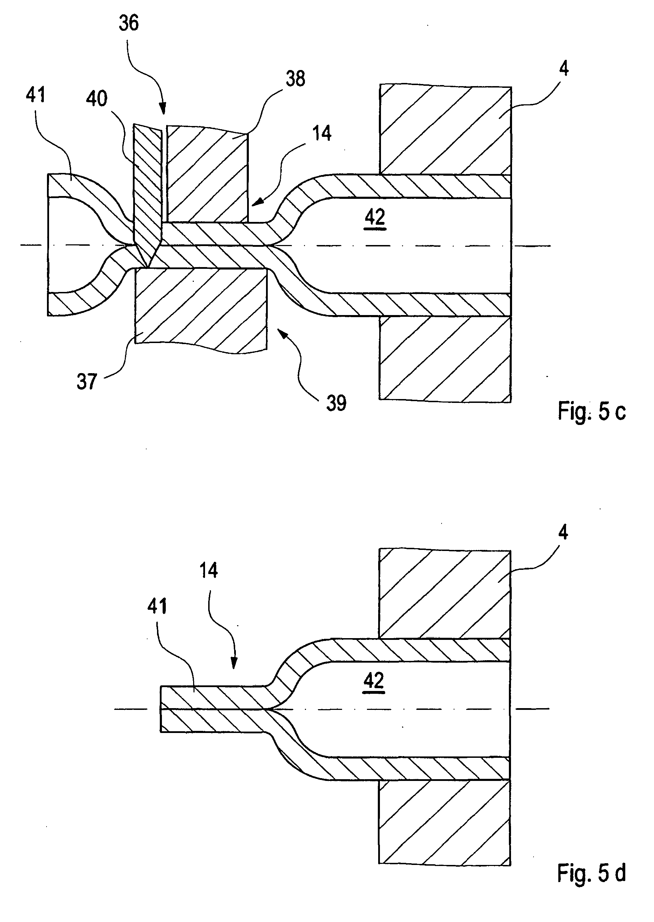

Nach der Ausbildung der im vorliegend dargestellten Ausführungsbeispiel vakuumdicht ausgeführten Ultraschallschweißverbindung 14 des Evakuierungsrohrs 12 wird das Schneidwerkzeug 40 des Kombinationswerkzeugs 39 nach vorne geschoben (in Fig. 5 nach unten). Ambosssonotrode 37 und Schweißsonotrode 38 wirken dabei einerseits als Positionierungsmittel. Andererseits ist die Ambosssonotrode 37 mit einer solchen Breite ausgebildet (insbesondere breiter als die Schweißsonotrode 38), sodass diese gleichzeitig als Anschlagfläche für das Schneidwerkzeug 40 dienen kann. Dieses ist insbesondere in Fig. 5c gut zu erkennen.

Durch die Vorwärtsbewegung des Schneidwerkzeugs 40 wird der überstehende Abschnitt 41 des Evakuierungsrohrs 12 abgelängt. In Fig. 5d ist die Anordnung nach Abschluss des Ablängvorgangs dargestellt.

Es ist jedoch durchaus denkbar, dass der überstehende Abschnitt 41 am Evakuierungsrohr 12 verbleiben kann. Dies ist in Fig. 1 dargestellt.

Nachdem das Evakuierungsrohr 12 vakuumdicht verschlossen wurde, wird nunmehr der thermisch aktivierbare Ionengetter 7 aktiviert. Beispielsweise handelt es sich bei dem thermisch aktivierbaren Ionengetter 7 um einen handelsüblichen St 172 SAES-Getter. Thermisch aktivierbare Ionengetter 7 aus diesem Material haben eine geringe Aktivierungstemperatur von 450° C (bei einer großen Menge von Gasresten im Hohlraum 2 können gegebenenfalls auch höhere Temperaturen von bis zu 900° C erforderlich werden; bei einer ausreichenden Vorbereitung der Bauteile der Detektorkapsel 1 - beispielsweise durch Entfetten, Reinigen , Ausheizen und Polieren der entsprechenden Oberflächen bzw. Bauteile - kann die erforderliche Aktivierungstemperatur jedoch in aller Regel in einem Bereich in der Nähe von 450° C belassen werden). Dazu wird der thermisch aktivierbare Ionengetter 7 schrittweise, das heißt periodisch alle zwei Minuten ein- bzw. abgeschaltet. Dies geschieht durch Beaufschlagung des thermisch aktivierbaren Ionengetters 7 mit einer entsprechenden Stromstärke über die elektrische Anschlussleitung 8. Nach zehn Minuten Behandlung ist der thermisch aktivierbare Ionengetter 7 aktiviert. Nunmehr dient der thermisch aktivierbare Ionengetter 7 als "dauerhafte Vakuumpumpe".

Ein Problem bei dem vorliegend eingesetzten thermisch aktivierbaren Ionengetter 7 besteht darin, dass während der Erhitzungsphase (zur thermischen Aktivierung des Ionengetters 7 und/oder im Laufe der Zeit durch die Absorption von Gasen durch den Ionengetter 7) kleine Partikel abplatzen können. Ein Kontakt von derartigen Partikeln aus Ionengettermaterial und dem Halbleiterdetektormaterial 6 ist jedoch zu vermeiden. Aus diesem Grund ist zwischen dem Aufnahmeraum 9 und dem Hohlraum 2 der Detektorkapsel 1 eine Filterscheibe 43 angeordnet. Die Filterscheibe 43 besteht im vorliegend dargestellten Ausführungsbeispiel der Detektorkapsel 1 aus einem Maschengewebe, welches in mehreren Lagen übereinander angeordnet ist. Das Maschengewebe selbst ist jeweils aus Edelstahl gefertigt, sodass auch die Filterscheibe 43 in üblicher Weise für den Einsatz in der Hochvakuumtechnik vorbereitet werden kann (beispielsweise durch Reinigen, Ausheizen und dergleichen). Dank der Filterscheibe 43 bleiben eventuelle vom thermisch aktivierbaren Ionengetter 7 abplatzende Teilchen im Aufnahmeraum 9 innerhalb des Deckels 4 gefangen, und können daher das Halbleiterdetektormaterial 6 nicht schädigen.

Da die Aufgabe der Filterscheibe 43, nämlich das Zurückhalten von Feststoffpartikeln auch mit einer relativ großen Maschenweite der eingesetzten Maschengewebe realisiert werden kann, entsteht nur ein relativ geringer Widerstand für das vom thermischen aktivierbaren Ionengetter 7 zu absorbierende Gas. Dadurch kann im Hohlraum 2 der Detektorkapsel 1 ein Vakuum mit höherer Güte zur Verfügung gestellt werden. Aufgrund der relativ großen Maschenweite des für die Filterscheibe 43 verwendeten Maschengewebes ist üblicherweise ein Durchtritt von Licht und/oder Infrarotstrahlung nach wie vor möglich. Die im vorliegend dargestellten Ausführungsbeispiel eingesetzte Filterscheibe 43 wirkt daher üblicherweise nicht thermisch isolierend. Selbstverständlich ist es aber auch möglich, dass die Filterscheibe 43 durch die Art ihrer Ausbildung bzw. ihrer Anordnung auch thermisch isolierend wirken kann.

Eine zusätzliche Offenbarung zu der vorliegend beschriebenen Erfindung ist in der deutschen Patentanmeldung enthalten, welche unter dem anmelderseitigen Aktenzeichen GSI08002-A am gleichen Tag beim deutschen Patent- und Markenamt als internationale Patentanmeldung (PCT-Anmeldung) hinterlegt wurde.

**Bezugszeichenliste:**

| | | | |
|---|---|---|---|
| 1: | Detektorkapsel | 29: | Schweißnaht |
| 2: | Hohlraum | 30: | mittlerer Bereich |
| 3: | Kapseldose | 31: | Kapsel-Deckel-Verschluss |
| 4: | Deckel | 32: | stegartiger Vorsprung |
| 5: | Boden | 33: | Schweißnaht |
| 6: | Halbleiterdetektormaterial | 34: | Rückseite |
| 7: | thermisch aktivierbarere lonengetter | 35: | Hohlraum |
| | | 36: | Kombinationswerkzeug |
| 8: | elektrische Anschlussleitung | 37: | Ambosssonotrode |
| 9: | Hohlraum | 38: | Schweißsonotrode |
| 10: | Spannungsdurchführung | 39: | Ultraschwallschweißwerkzeug |
| 11: | elektrische Leitung | 40: | Schneidwerkzeug |
| 12: | Evakuierungsrohr | 41: | überstehender Abschnitt |
| 13: | Schweißnaht | 42: | Innenquerschnitt |
| 14: | Verschlussbereich | 43: | Filterscheibe |
| 15: | Verbindungsbereich | | |
| 16: | Stützsteg | | |
| 17: | Randbereich | | |
| 18: | Kontaktsteg | | |
| 19: | Brückensteg | | |
| 20: | Nut | | |
| 21: | Hauptkörper | | |
| 22: | CO₂-Laser | | |
| 23: | Laserstrahl | | |
| 24: | Stirnbereich | | |
| 25: | Schweißnahtwurzel | | |
| 26: | Schutzgasdüse | | |
| 27: | Kontaktbereich | | |
| 28: | Kapsel-Deckel-Verschluss | | |

## Patentansprüche

1. Vakuumdicht verschließbares Gehäuse (1), insbesondere vakuumdicht verschließbares Gehäuse (1) für unter Vakuum und/oder Schutzgas betriebene Geräte (6), aufweisend zumindest einen Gehäuseinnenraum (2) sowie zumindest einen Aufnahmebereich (9) zur Aufnahme eines Gettermaterials (7), **dadurch gekennzeichnet, dass** die Verbindung zwischen dem zumindest einen Gehäuseinnenraum (2) und dem zumindest einen Aufnahmebereich (7) zur Aufnahme eines Gettermaterials (9) mittels zumindest einer Filtereinrichtung (43) als partikelundurchlässige, fluiddurchlässige Verbindung (43) ausgeführt ist, wobei die zumindest eine Filtereinrichtung (43) eine Mehrzahl von übereinander angeordneten Maschengeweben aufweist.

2. Gehäuse (1) nach Anspruch 1, **dadurch gekennzeichnet**, das zumindest ein Aufnahmebereich (9) zur Aufnahme eines Gettermaterials (7) zumindest bereichsweise in einem massiv ausgeführten Gehäusebereich (4) ausgebildet ist.

3. Gehäuse (1) nach einem der vorangehenden Ansprüche, **gekennzeichnet durch** zumindest ein Gettermaterial (7), welches bevorzugt in zumindest einem der Aufnahmebereiche (9) zur Aufnahme eines Gettermaterials (7) angeordnet ist, wobei besonders bevorzugt zumindest ein Gettermaterial (7) als thermisch aktivierbares Gettermaterial (7) ausgebildet ist.

4. Gehäuse (1) nach einem der vorangehenden Ansprüche, **gekennzeichnet durch** zumindest eine, die Gehäusewand (4) durchdringende Durchführungseinrichtung (10, 12), die bevorzugt fluiddicht verschlossen (14) werden kann.

5. Gehäuse (1) nach einem der vorangehenden Ansprüche, **gekennzeichnet durch** zumindest eine thermische Isolationseinrichtung (20, 35), welche in zumindest einem Verbindungsbereich (15, 27, 34) in der Nähe wenigstens einer stoffschlüssigen Verbindungsnaht (13, 29, 33) vorgesehen ist.

6. Gehäuse (1) nach Anspruch 5, **dadurch gekennzeichnet, dass** wenigstens eine thermische Isolationseinrichtung (20, 35) als Materialverdünnung (20, 35), insbesondere als Ausnehmung (20, 35), bevorzugt als nutartige Ausnehmung (20) und/oder als stegartiger Vorsprung (35) ausgebildet ist.

7. Gehäuse (1) nach einem der vorangehenden Ansprüche, insbesondere nach Anspruch 5 oder 6, **dadurch gekennzeichnet, dass** zumindest zwei der miteinander verbundenen Verbindungsbereiche (3, 4), insbesondere zwei miteinander verbundene Gehäuseteile (3, 4), zumindest bereichsweise eine unterschiedliche Dicke aufweisen.

8. Gehäuse (1) nach einem der vorangehenden Ansprüche, **dadurch gekennzeichnet, dass** zumindest zwei Verbindungsbereiche (3, 4) des Gehäuses (1) zumindest bereichsweise mit einer Übergangspassung und/oder mit einer Presspassung versehen sind, insbesondere mit einer H7-Passung.

9. Gehäuse (1) nach einem der vorangehenden Ansprüche, insbesondere nach einem der Ansprüche 5 bis 8, **dadurch gekennzeichnet, dass** zwischen einem Gehäusemantel (3) und einem Gehäusedeckel (4) und/oder Gehäuseboden zumindest eine Verbindungsnaht (13, 29, 33) vorgesehen ist.

10. Gehäuse (1) nach einem der vorangehenden Ansprüche, insbesondere nach einem der Ansprüche 5 bis 8, **dadurch gekennzeichnet, dass** zumindest ein Gehäuseteil (3, 4), insbesondere zumindest ein Verbindungsbereich (15, 27, 34), zumindest ein Material aufweist, welches der Gruppe entnommen ist, die Metall, Metalllegierungen, Aluminium, Aluminiumlegierungen, AlMg₃, AlMg₄,₅Mn, Stahl, Stahllegierungen, Edelstahl, Kupfer, Kupferlegierungen, Nickel, Nickellegierungen, abdampfarme Materialien und/oder abdampffreie Materialien umfasst.

11. Gehäuse (1) nach einem der vorangehenden Ansprüche, insbesondere nach einem der Ansprüche 5 bis 10, **dadurch gekennzeichnet, dass** wenigstens eine Verbindungsnaht (13, 29, 33), insbesondere eine stoffschlüssige Verbindungsnaht (13, 29, 33) trennbar ausgeführt ist, und insbesondere geöffnet werden kann, bevorzugt geöffnet und erneut verschlossen werden kann.

12. Gerät, insbesondere unter Vakuum und/oder Schutzgas betriebenes Gerät, **gekennzeichnet durch** wenigstens ein Gehäuse (1) nach einem der vorangehenden Ansprüche, wobei das Gerät bevorzugt als Detektor, insbesondere als Halbleiterdetektor (6) ausgebildet ist.

## Claims

1. Vacuum-tightly sealable housing (1), in particular a vacuum-tightly sealable housing (1) for devices (6) operated under vacuum and/or inert gas, comprising at least one interior housing space (2) together with at least one receiving region (9) for the reception of a getter material (7), **characterized in that** the connection between the at least one interior housing space (2) and the at least one receiving region (7) for the reception of a getter material (9) is implemented by means of at least one filter apparatus (43) as a particle-impermeable and fluid-permeable connection (43), wherein the at least one filter apparatus (43) comprises a plurality of mesh fabrics arranged on top of one another.

2. Housing (1) according to Claim 1, **characterized in that** at least one receiving region (9) for the reception of a getter material (7) is formed at least in some regions in a region of the housing (4) made of solid material.

3. Housing (1) according to one of the preceding claims, **characterized by** at least one getter material (7), which is preferably arranged in at least one of the receiving regions (9) for receiving a getter material (7), wherein it is particularly preferred that at least one getter material (7) is implemented as a getter material (7) that can be activated thermally.

4. Housing (1) according to one of the preceding claims, **characterized by** at least one feedthrough apparatus (10, 12) penetrating the housing wall (4) and which can preferably be closed (14) impermeably to fluids.

5. Housing (1) according to one of the preceding claims, **characterized by** at least one thermal insulation apparatus (20, 35) which is provided in at least one connecting region (15, 27, 34) close to at least one materially bonded connecting seam (13, 29, 33).

6. Housing (1) according to Claim 5, **characterized in that** at least one thermal insulation apparatus (20, 35) is implemented as a thinning of the material (20, 35), in particular as a recess (20, 35), preferably as a groove-like recess (20) and/or as a bar-like projection (35).

7. Housing (1) according to one of the preceding claims, in particular according to Claim 5 or 6, **characterized in that** at least two of the connecting regions (3, 4) that are connected to one another, in particular two parts of the housing (3, 4) that are connected to one another, exhibit a different thickness at least in some regions.

8. Housing (1) according to one of the preceding claims, **characterized in that** at least two connecting regions (3, 4) of the housing (1) are provided at least in some regions with a transition fit and/or with a press fit, in particular with an H7 fit.

9. Housing (1) according to one of the preceding claims, in particular according to one of claims 5 to 8, **characterized in that** at least one connecting seam (13, 29, 33) is provided between a housing jacket (3) and a housing lid (4) and/or housing floor.

10. Housing (1) according to one of the preceding claims, in particular according to one of claims 5 to 8, **characterized in that** at least one part of the housing (3, 4), in particular at least one connecting region (15, 27, 34), comprises at least one material that is selected from the group comprising metal, metal alloys, aluminium, aluminium alloys, AlMg₃, AlMg₄,₅Mn, steel, steel alloys, stainless steel, copper, copper alloys, nickel, nickel alloys, low evaporation materials and/or evaporation-free materials.

11. Housing (1) according to one of the preceding claims, in particular according to one of claims 5 to 10, **characterized in that** at least one connecting seam (13, 29, 33), in particular a materially bonded connecting seam (13, 29, 33), is implemented separably, and in particular can be opened, and preferably can be opened and then sealed again.

12. Device, in particular a device operated under vacuum and/or inert gas, **characterized by** at least one housing (1) according to one of the preceding claims, wherein the device is preferably implemented as a detector, in particular as a semiconductor detector (6).

## Revendications

1. Boîtier (1) fermant de manière étanche au vide, en particulier boîtier (1) fermant de manière étanche au vide destiné à des appareils (6) fonctionnant sous vide et/ou sous gaz protecteur, comprenant au moins un compartiment intérieur de boîtier (2) ainsi qu'au moins une zone réceptrice (9) destinée à recevoir un matériau getter (7), **caractérisé en ce que** la liaison entre l'au moins un compartiment intérieur de boîtier (2) et l'au moins une zone réceptrice (7) destinée à recevoir un matériau getter (9) est réalisée sous forme d'une liaison (43) imperméable aux particules et perméable aux fluides au moyen d'au moins un dispositif filtrant (43), l'au moins un dispositif filtrant (43) présentant une pluralité de tissus maillés superposés.

2. Boîtier (1) selon la revendication 1, **caractérisé en ce qu'**au moins une zone réceptrice (9) destinée à recevoir un matériau getter (7) est formée au moins partiellement dans une zone de boîtier (4) réalisée de manière massive.

3. Boîtier (1) selon l'une des revendications précédentes, **caractérisé par** au moins un matériau getter (7) qui est de manière préférée disposé dans au moins une zone réceptrice (9) destinée à recevoir un matériau getter (7), sachant que de manière particulièrement préférée, au moins un matériau getter (7) est développé en tant que matériau getter (7) thermiquement activable.

4. Boîtier (1) selon l'une des revendications précédentes, **caractérisé par** au moins un dispositif de passage (10, 12) qui traverse la paroi de boîtier (4) et peut de préférence être fermé de manière étanche aux fluides (14).

5. Boîtier (1) selon l'une des revendications précédentes, **caractérisé par** au moins un dispositif d'isolation thermique (20, 35) qui est prévu dans au moins une zone de liaison (15, 27, 34) à proximité d'au moins un cordon de raccord par liaison de matière (13, 29, 33).

6. Boîtier (1) selon la revendication 5, **caractérisé en ce qu'**au moins un dispositif d'isolation thermique (20, 35) est conçu en tant qu'amincissement de matière (20, 35), en particulier en tant qu'évidement (20, 35), de préférence en tant qu'évidement en forme de gorge (20) et/ou en tant que saillie en forme de nervure (35).

7. Boîtier (1) selon l'une des revendications précédentes, en particulier selon la revendication 5 ou 6, **caractérisé en ce qu'**au moins deux des zones de liaison (3, 4) reliées entre elles, en particulier deux parties de boîtier (3, 4) reliées entre elles, présentent au moins partiellement des épaisseurs différentes.

8. Boîtier (1) selon l'une des revendications précédentes, **caractérisé en ce qu'**au moins deux zones de liaison (3, 4) du boîtier (1) sont munies au moins partiellement d'un ajustement de transition et/ou d'un ajustement serré, en particulier d'un ajustement H7.

9. Boîtier (1) selon l'une des revendications précédentes, en particulier selon l'une des revendications 5 à 8, **caractérisé en ce qu'**est prévu au moins un cordon de raccord (13, 29, 33) entre une enveloppe de boîtier (3) et un couvercle de boîtier (4) et/ou un fond de boîtier.

10. Boîtier (1) selon l'une des revendications précédentes, en particulier selon l'une des revendications 5 à 8, **caractérisé en ce qu'**au moins une partie de boîtier (3, 4), en particulier au moins une zone de liaison (15, 27, 34), présente au moins un matériau prélevé dans le groupe qui comprend du métal, des alliages métalliques, de l'aluminium, des alliages d'aluminium, de l'AlMg₃, de l'AlMg₄,₅Mn, de l'acier, des alliages d'acier, de l'acier spécial, du cuivre, des alliages de cuivre, du nickel, des alliages de nickel, des matériaux à faible évaporation et/ou des matériaux exempts d'évaporation.

11. Boîtier (1) selon l'une des revendications précédentes, en particulier selon l'une des revendications 5 à 10, **caractérisé en ce qu'**au moins un cordon de raccord (13, 29, 33), en particulier un cordon de raccord par liaison de matière (13, 29, 33), est réalisé de manière dissociable et peut en particulier être ouvert, de préférence ouvert et de nouveau fermé.

12. Appareil, en particulier appareil fonctionnant sous vide et/ou gaz protecteur, **caractérisé par** au moins un boîtier (1) selon l'une des revendications précédentes, l'appareil étant de préférence conçu en tant que détecteur, en particulier en tant que détecteur à semiconducteurs (6).
